# EUROPEAN PATENT APPLICATION

(11) **EP 4 512 940 A1**
(43) Date of publication of application: **26.02.2025**
(21) Application number: 22945175.2
(22) Date of filing: 07.06.2022
(51) Int. Cl.: C30B 15/00, C30B 15/36, C30B 29/36, C30B 11/00, C30B 11/14, C30B 19/06

(54) **CRYSTAL PREPARATION APPARATUS AND CRYSTAL PREPARATION METHOD**

(71) Applicant: MEISHAN BOYA ADVANCED MATERIALS CO., LTD., Meishan, Sichuan 620010 (CN)
(72) Inventor: WANG, Yu, Sichuan 620010 (CN); GUAN, Weiming, Sichuan 620010 (CN); LIANG, Zhenxing, Sichuan 620010 (CN); LI, Min, Sichuan 620010 (CN)
(74) Representative: Wang, Bo
(86) International application number: PCT/CN2022/097279
(87) International publication number: WO 2023/236025

(57) **Abstract**

A crystal preparation apparatus (100) and a crystal preparation method (700). The crystal preparation apparatus (100) comprises: a growth cavity (110), the growth cavity (110) being internally provided with at least one layer of plate assembly (111); and a heating assembly (120), used for heating the growth cavity (110). The crystal preparation method (700) comprises: placing a raw material in the growth cavity (110) (710), the growth cavity (110) being internally provided with at least one layer of plate assembly (111); heating the growth cavity (110) by means of the heating assembly (120) so as to melt the raw material into a melt (720); bonding a seed crystal (180) to a seed crystal holder (150) (730); lowering the seed crystal holder (150) to which the seed crystal (180) is bonded, so that the seed crystal (180) is in contact with the melt; and preparing a crystal on the basis of the seed crystal (180) and the melt (750).

## Description

### TECHNICAL FIELD

The present disclosure relates to the field of crystal preparation technology, and in particular, to a crystal preparation apparatus and a crystal preparation method based on a liquid phase technique.

### BACKGROUND

When preparing a crystal (e.g., silicon carbide) based on a liquid phase technique (e.g., liquid phase epitaxy (LPE)), volatile components in a raw material may move upward or even evaporate into a gaseous state and continue to spill over to an external insulation assembly, resulting in excessive consumption of the raw material. Further, the volatilization process leads to a deviation of the components in the raw material, which affects the growth of the crystal. In addition, overflowing vapors can affect the insulation performance of the insulation assembly. Therefore, it is desirable to provide a crystal preparation apparatus that improves the movement of the volatile components and further ensures the normal growth of the crystal.

### SUMMARY

One of the embodiments of the present disclosure provides a crystal preparation apparatus. The crystal preparation apparatus may include a growth cavity and a heating assembly. The growth cavity may be provided with one or more plate assemblies, each of the one or more plate assemblies being arranged as a layer. The heating assembly may be configured to heat the growth cavity.

In some embodiments, one of the one or more plate assemblies may include one or more through holes.

In some embodiments, through holes of adj acent plate assemblies may be interleaved.

In some embodiments, for a plate assembly of the one or more plate assemblies, a ratio of a sum of open areas of the one or more through holes to an area of an upper surface of the plate assembly may be within a range of 30%-80%.

In some embodiments, a density of the one or more through holes may decrease progressively from a center to an edge of a plate assembly among the one or more plate assemblies.

In some embodiments, a ratio of a density of through holes near a center of a plate assembly among the one or more plate assemblies to a density of through holes near an edge of the plate assembly may be within a range of 1: 1-20: 1.

In some embodiments, a diameter of each of the one or more through holes may be within a range of 0.1 mm-10 mm.

In some embodiments, the one or more plate assemblies may be disposed within a melt within the growth cavity and may be disposed at a predetermined distance below a liquid level of the melt.

In some embodiments, a distance between adjacent plate assemblies may be within a range of 10 mm-60 mm.

In some embodiments, an upper portion with a predetermined range of a sidewall of the growth cavity may be coated with a coating or provided with a shielding ring.

In some embodiments, the predetermined range may be within a range of 0-2/3 along a height direction of the growth cavity.

In some embodiments, the crystal preparation apparatus may further include a cavity cover and an upper insulation member. A gap between the cavity cover and the upper insulation member may be filled with toner.

In some embodiments, the cavity cover may include a raised structure.

In some embodiments, a thickness of a sidewall of the growth cavity may be progressively increased in a direction from a top portion to a bottom portion of the growth cavity.

In some embodiments, the heating assembly may include an induction coil. The induction coil may be disposed around an outer periphery of the growth cavity, and a ratio of a height of the growth cavity to a height of the induction coil may be within a range of 1:1-1:5.

In some embodiments, the crystal preparation apparatus may further include a seed crystal holder configured to bond one or more seed crystals. The one or more seed crystals may be arranged in at least two layers.

In some embodiments, the one or more seed crystals may be arranged in at least two layers. The one or more seed crystals may include a first seed crystal and a second seed crystal, the first seed crystal may be bonded to the seed crystal holder, and the second seed crystal may be bonded to the first seed crystal. A mass of the first seed crystal may be lower than a mass of the second seed crystal.

In some embodiments, a graphite paper may be filled between the seed crystal holder and the seed crystals.

One of the embodiments of the present disclosure further provides a crystal preparation method. The method may include placing a raw material within a growth cavity, the growth cavity being provided with one or more plate assemblies, each of the one or more plate assemblies being arranged as a layer; heating the growth cavity by a heating assembly to melt the raw material into a melt; bonding one or more seed crystals to a seed crystal holder; lowering the seed crystal holder with the one or more seed crystals so that the one or more seed crystals are in contact with the melt; and preparing a crystal based on the one or more seed crystals and the melt.

In some embodiments, the one or more seed crystals may be arranged in at least two layers. The one or more seed crystals may include a first seed crystal and a second seed crystal, the first seed crystal may be bonded to the seed crystal holder, and the second seed crystal may be bonded to the first seed crystal. A mass of the first seed crystal may be lower than a mass of the second seed crystal.

In some embodiments, a graphite paper may be filled between the seed crystal holder and the one or more seed crystals.

In some embodiments, a ratio of a height of the melt to a height of the growth cavity may be within a range of 1:1-1:5.

### BRIEF DESCRIPTION OF THE DRAWINGS

The present disclosure is further illustrated in terms of exemplary embodiments. These exemplary embodiments are described in detail with reference to the drawings. These embodiments are non-limiting exemplary embodiments, in which like reference numerals represent similar structures, and wherein:
FIG. 1 is a schematic diagram illustrating an exemplary crystal preparation apparatus according to some embodiments of the present disclosure;
FIG. 2 is a schematic diagram illustrating through holes in an exemplary plate assembly according to some embodiments of the present disclosure;
FIG. 3 is a schematic diagram illustrating through holes in an exemplary plate assembly according to some embodiments of the present disclosure;
FIG. 4 is a schematic diagram illustrating a localized structure of an exemplary cavity cover with an upper insulation member according to some embodiments of the present disclosure;
FIG. 5 is a schematic diagram illustrating an exemplary growth cavity according to some embodiments of the present disclosure;
FIG. 6 is a schematic diagram illustrating an exemplary seed crystal holder and a seed crystal according to some embodiments of the present disclosure; and
FIG. 7 is a flowchart illustrating an exemplary crystal preparation method according to some embodiments of the present disclosure.

In the figure, 100 represents a crystal preparation apparatus, 110 represents a growth cavity, 120 represents a heating assembly, 111 represents a plate assembly, 1111 represents a through hole, 130 represents a cavity cover, 131 represents a gap, 132 represents a raised structure, 140 represents an insulation member, 141 represents an upper insulation member, 142 represents a middle insulation member, 143 represents a cavity bottom insulation member, 144 represents a lower insulation member, 150 represents a seed crystal holder, 160 represents a connecting assembly, 170 represents a cover plate, 180 represents a seed crystal, 181 represents a first seed crystal, 182 represents a second seed crystal, and 190 represents graphite paper.

### DETAILED DESCRIPTION

To more clearly illustrate the technical solutions related to the embodiments of the present disclosure, a brief introduction of the drawings referred to the description of the embodiments is provided below. Obviously, the drawings described below are only some examples or embodiments of the present disclosure. Those having ordinary skills in the art, without further creative efforts, may apply the present disclosure to other similar scenarios according to these drawings. Unless obviously obtained from the context or the context illustrates otherwise, the same numeral in the drawings refers to the same structure or operation.

It should be understood that "system", "device", "unit" and/or "module" as used herein is a manner used to distinguish different components, elements, parts, sections, or assemblies at different levels. However, if other words serve the same purpose, the words may be replaced by other expressions.

As shown in the present disclosure and claims, the words "one", "a", "a kind" and/or "the" are not especially singular but may include the plural unless the context expressly suggests otherwise. In general, the terms "comprise", "comprises", "comprising", "include", "includes", and/or "including", merely prompt to include operations and elements that have been clearly identified, and these operations and elements do not constitute an exclusive listing. The methods or devices may also include other operations or elements.

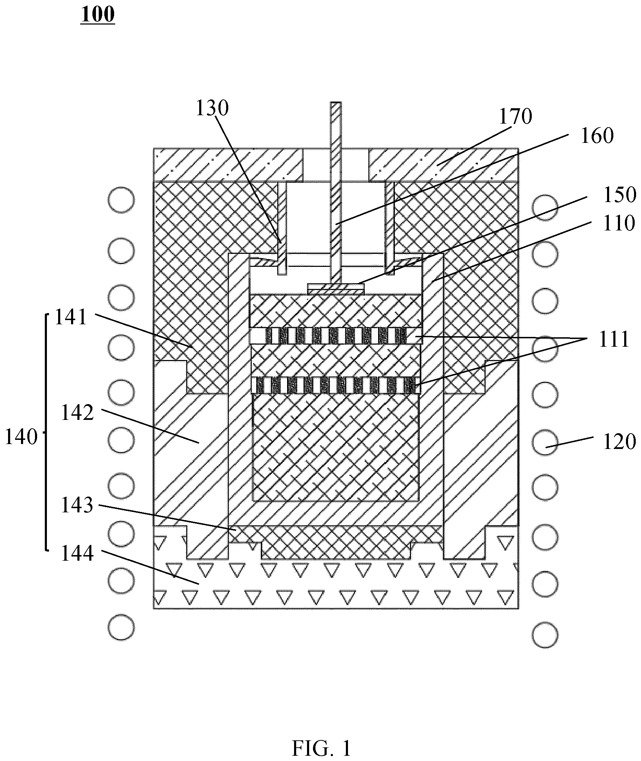

FIG. 1 is a schematic diagram illustrating an exemplary crystal preparation apparatus according to some embodiments of the present disclosure.

In some embodiments, the crystal preparation apparatus 100 may prepare a crystal (e.g., silicon carbide) based on a liquid phase technique. In the following, the crystal preparation apparatus 100 covered by the embodiments in the present disclosure will be described in detail in connection with the accompanying drawings, using the preparation of a silicon carbide crystal as an example. It should be noted that the following embodiments are merely for explaining the present disclosure and do not constitute a limitation of the present disclosure.

As shown in FIG. 1, the crystal preparation apparatus 100 may include a growth cavity 110 and a heating assembly 120.

The growth cavity 110 serves as a site for crystal preparation, and the heating assembly 120 is configured to heat the growth cavity 110 to provide the heat (e.g., temperature, temperature field, etc.) required for crystal preparation.

In some embodiments, the material of the growth cavity 110 may be determined based on the type of crystal to be prepared. For example, when preparing the silicon carbide crystal, the material of the growth cavity 110 may include graphite. In some embodiments, the material of the growth cavity 110 may include molybdenum, tungsten, tantalum, or the like. In some embodiments, the growth cavity 110 may provide the raw material necessary to prepare the crystal. For example, the growth cavity 110 may serve as a carbon source, providing the carbon needed to prepare the silicon carbide crystal. In some embodiments, the raw material (e.g., silicon powder, toner) required for preparing the crystal may be placed within the growth cavity 110. In some embodiments, the growth cavity 110 may be a site for the raw material to form a melt. For example, under the action of the high temperature generated by the heating assembly 120, the silicon powder melts into the melt (i.e., silicon solution), and the carbon provided by the growth cavity 110 is dissolved in the silicon solution to form a solution of carbon in silicon, which serves as a liquid raw material for preparing the silicon carbide crystal using the liquid phase technique. In some embodiments, fluxes (e.g., aluminum, silicon-chromium alloys, Li-Si alloys, Ti-Si alloys, Fe-Si alloys, Sc-Si alloys, Co-Si alloys, or the like) may be added to the raw material to increase the solubility of carbon in silicon.

In some embodiments, an upper portion with a predetermined range of an inner sidewall of the growth cavity 110 may be coated or provided with a shielding ring to avoid spontaneous nucleation of crystalline growth by reacting silicon near the surface of the melt with the carbon on the sidewall of the growth cavity 110. In some embodiments, the coating or shielding ring may be made of a high temperature resistant metal (e.g., tungsten, tantalum, molybdenum, chromium, aluminum, etc.) or a metal compound (e.g., zirconium oxide, aluminum oxide, etc.).

In some embodiments, the upper portion with the predetermined of the inner sidewall of the growth cavity 100 may be within a range of 0-2/3 of the inner sidewall of the growth cavity 100 along the height direction of the growth cavity. In some embodiments, the upper portion with the predetermined of the inner sidewall of the growth cavity 100 may be within a range of 0-1/3 of the inner sidewall of the growth cavity 100 along the height direction of the growth cavity. In some embodiments, the upper portion with the predetermined of the inner sidewall of the growth cavity 100 may be within a range of 0-1/4 of the inner sidewall of the growth cavity 100 along the height direction of the growth cavity.

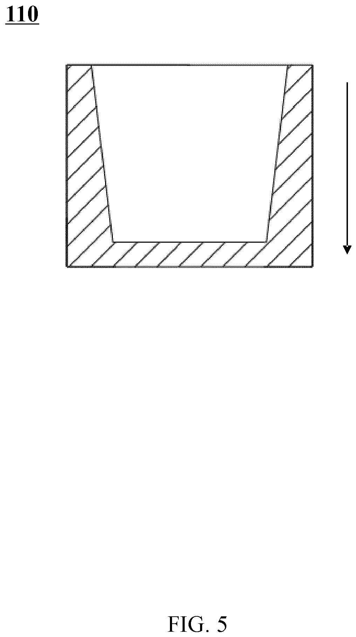

More description regarding the growth cavity 110 may be found elsewhere in the present disclosure (e.g., FIG. 5 and its description) and will not be repeated here.

In some embodiments, the heating assembly 120 may include an induction heating assembly, a resistance heating assembly, or the like. In some embodiments, the heating assembly 120 may be disposed around the outer periphery of the growth cavity 110.

In some embodiments, the heating assembly 120 may include an induction coil. In some embodiments, the induction coil may be disposed around the outer periphery of the growth cavity 110. In some embodiments, a ratio of a height of the growth cavity 110 to a height of the induction coil needs to be within a predetermined range in order to ensure the temperature field required for crystal growth and to improve the crystal growth efficiency.

In some embodiments, the ratio of the height of the growth cavity 110 to the height of the induction coil may be within a range of 1:1-1:5. In some embodiments, the ratio of the height of the growth cavity 110 to the height of the induction coil may be within a range of 1: 1.5-1 :4.5. In some embodiments, the ratio of the height of the growth cavity 110 to the height of the induction coil may be within a range of 1 :2-1:4. In some embodiments, the ratio of the height of the growth cavity 110 to the height of the induction coil may be within a range of 1:2.5-1:3.5. In some embodiments, the ratio of the height of the growth cavity 110 to the height of the induction coil may be within a range of 1:2.8-1:3.

In some embodiments, one or more plate assemblies 111 may be disposed within the growth cavity 110, and each of one or more plate assemblies 111may be arranged as a layer. In some embodiments, the plate assemblies 111 may be disposed within the melt in the growth cavity 110.

When growing the silicon carbide crystal, convection occurs in the melt within the growth cavity 110, and silicon moves upwardly from the bottom of the growth cavity 110, or even evaporates from a liquid state to a gaseous state and continues to overflow upwardly, resulting in an excessive consumption of silicon. In addition, the upwardly overflowing silicon vapors may spill out of the growth cavity 110 and attach to the insulation assembly outside the cavity, contaminating the insulation assembly and affecting the insulation performance. Correspondingly, the plate assemblies 111 arranged as a layer provided within the growth cavity may alter the convection of the melt, slowing down the upward movement of the silicon and avoiding overconsumption, while avoiding or reducing the amount of silicon vapor that overflows outside the cavity, avoiding or reducing contamination of the insulation assembly.

In some embodiments, the material of the plate assemblies 111 may be determined based on the type of crystal to be prepared. For example, when preparing the silicon carbide crystal, the plate assemblies 111 are made of the same material as the growth cavity 110 (e.g., graphite). The graphite may be used as a carbon source to provide the carbon needed to prepare the silicon carbide crystal, and may also react with silicon to form silicon carbide, which accordingly reduces the consumption of the growth cavity 110 and may further increase the number of times the growth cavity 110 can be used.

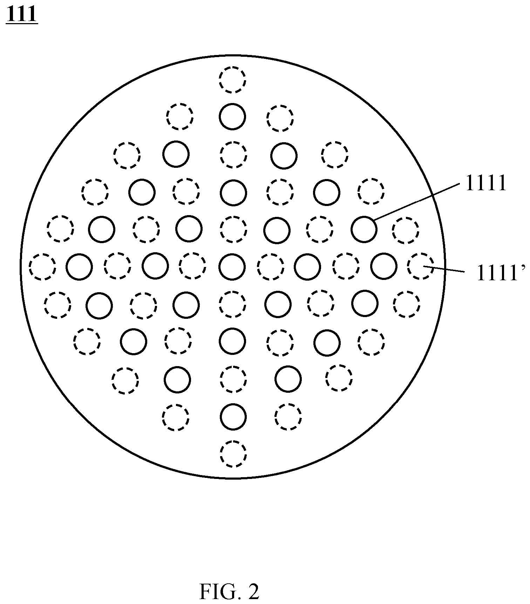

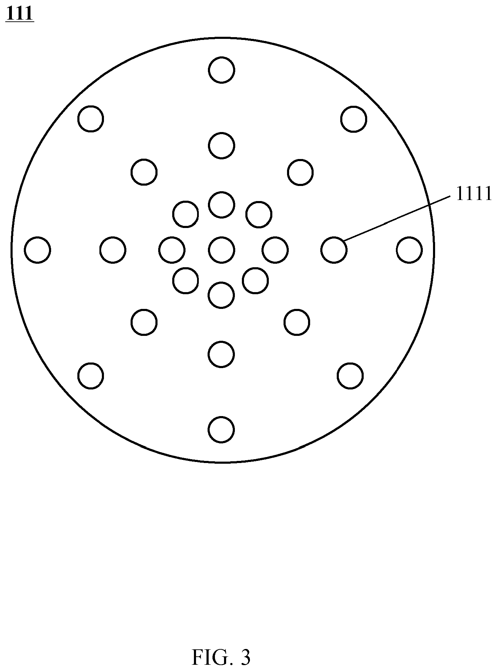

In some embodiments, one or more through holes may be included in each of the one or more plate assemblies 111. The through holes may serve as channels for melt convection or movement. In some embodiments, in order to slow down the upward movement of the silicon while meeting the convection or movement requirements, the through holes are designed to meet predetermined conditions. More descriptions may be found in FIG. 2 and FIG. 3, which will not be repeated here.

In some embodiments, when the heating assembly 120 is an induction heating assembly (as shown in FIG. 1), at least one of the one or more plate assemblies 111 may serve as a heat source to provide the heat required for crystal preparation (e.g., heat energy to dissolve the raw material into a melt required for crystal growth, and the temperature field required for crystal growth).

In some embodiments, the plate assemblies 111 (e.g., the uppermost plate assemblies) may be located a predetermined distance below the liquid level of the melt. In some embodiments, the distance that the plate assemblies 111 (e.g., the uppermost plate assemblies) is located below the liquid level of the melt affects the channels, paths, etc., by which the melt raw material required for crystal growth is transported to the surface on which the crystal is grown, which in turn affects the quality of the crystal that is grown. Therefore, the predetermined distance needs to be within a predetermined range.

In some embodiments, the predetermined distance may be within a range of 10 mm-50 mm. In some embodiments, the predetermined distance may be in the range of 15 mm-45 mm.

In some embodiments, the predetermined distance may be within a range of 20 mm-40 mm. In some embodiments, the predetermined distance may be within a range of 25 mm-35 mm. In some embodiments, the predetermined distance may be within a range of 28 mm-32 mm.

In some embodiments, to improve the stability of crystal growth, the plate assemblies 111 (e.g., the lowermost plate assemblies) may be in a location near the midpoint of the height of the melt or the heating assemblies (e.g., the induction coil). In some embodiments, the location near the midpoint of the height of the melt or the heating assembly refers to a location within a predetermined distance. In some embodiments, the predetermined distance may include ±50 cm, ±40 cm, ±30 cm, ±20 cm, ±10 cm, ±8 cm, ±6 cm, ±4 cm, ±2 cm, ±1 cm, etc. For example, the location near the midpoint of the height of the melt may include a location within a range of ±30 cm of 1/2 the height of the melt.

In some embodiments, a distance between two adjacent plate assemblies 111 affects the temperature field near the crystal growth interface, the supply of raw materials (e.g., carbon, silicon) required for growth and their transport paths to the crystal growth interface, or the like. Thus, the distance between two adjacent plate assemblies 111 needs to be within a predetermined range.

In some embodiments, the distance between adjacent plate assemblies 111 may be within a range of 10mm-60mm. In some embodiments, the distance between adjacent plate assemblies 111 may be within a range of 15mm-55mm. In some embodiments, the distance between adjacent plate assemblies 111 may be within a range of 20mm-50mm. In some embodiments, the distance between adjacent plate assemblies 111 may be within a range of 25mm-45mm. In some embodiments, the distance between adjacent plate assemblies 111 may be within a range of 30mm-40mm. In some embodiments, the distance between adjacent plate assemblies 111 may be within a range of 34mm-36mm.

In some embodiments, the crystal preparation apparatus 100 may further include a cavity cover 130. In some embodiments, the shape and dimensions of the cavity cover 130 may be compatible with the growth cavity 110. In some embodiments, the cavity cover 130 may be sealably connected or removably connected (e.g., snap-fit) with the growth cavity 110.

In some embodiments, the crystal preparation apparatus 100 may further include an insulation assembly 140 for insulating the growth cavity 110. In some embodiments, the insulation assembly 140 may be disposed around the outer periphery of the growth cavity 110. In some embodiments, the insulation assembly 140 may be disposed around the exterior of the heating assembly 120.

In some embodiments, the insulation assembly 140 may include an upper insulation member 141, a middle insulation member 142, a cavity bottom insulation member 143, and a lower insulation member 144.

In some embodiments, the upper insulation member 141 may be located in the upper portion of the growth cavity 110, as shown in FIG. 1. In some embodiments, the middle insulation member 142 may be disposed in a lower portion of the growth cavity 110 or below the upper insulation member 141. In some embodiments, the cavity bottom insulation member 143 may be located at the bottom portion of the growth cavity 110. In some embodiments, the lower insulation component 144 may be located below the middle insulation member 142 and the cavity bottom insulation member 143. In some embodiments, adjacent insulation members (e.g., the upper insulation member 141 and the middle insulation member 142, the middle insulation member 142 and the lower insulation component 144, the cavity bottom insulation member 143 and the lower insulation component 144) may be detachably connected (e.g., fit-to-fit) to facilitate removal and replacement of damaged insulation members.

In some embodiments, each insulation member (e.g., the upper insulation member 141, the middle insulation member 142, the cavity bottom insulation member 143, and the lower insulation component 144) may include a block insulation material, a granular insulation material, a flocculent insulation material, a lamellar insulation material, or the like, or a combination thereof. In some embodiments, the material of each insulation member may include quartz (silicon oxide), corundum (alumina), zirconia, carbon fiber, ceramics, or the like, or other high-temperature-resistant materials (e.g., rare-earth metal boride, carbide, nitride, silicide, phosphide, sulfide, or the like). In some embodiments, the materials of different insulation members may be the same or different.

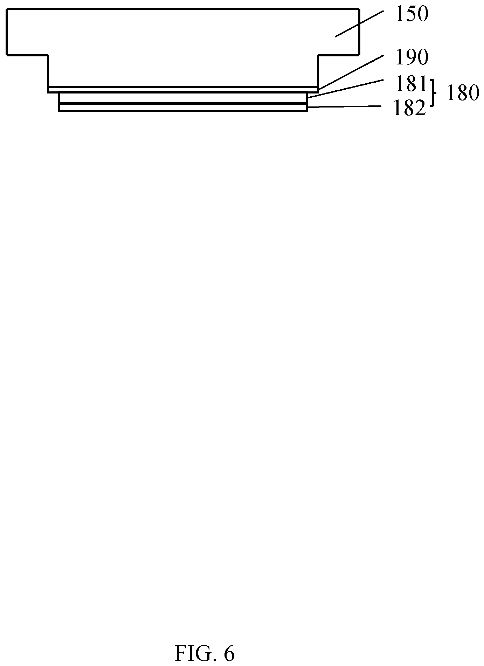

In some embodiments, the crystal preparation apparatus 100 may further include a seed crystal holder 150 configured to bond one or more seed crystals. In some embodiments, the material of the seed crystal holder 150 may include graphite. Descriptions regarding the seed crystal holder 150 and the seed crystal may be found elsewhere in the present disclosure (e.g., FIG. 6 and its description) and will not be repeated here.

In some embodiments, the crystal preparation apparatus 100 may further include a connecting assembly 160 for connecting the seed crystal holder 150. In some embodiments, the connecting assembly 160 may be a cylinder, a prism, etc. In some embodiments, the connecting assembly 160 may be formed in one piece or by connecting a plurality of connecting parts to each other. In some embodiments, the material of the connecting assembly 160 may include, but is not limited to, graphite, or the like.

In some embodiments, the crystal preparation apparatus 100 may also include a power assembly (not shown in the figures) for driving the connecting assembly 160 to rotate and/or move up and down to drive the seed crystal holder 150 to rotate and/or move up and down to grow crystals.

In some embodiments, the crystal preparation apparatus 100 may further include a cover plate 170. In some embodiments, the cover plate 170 may be configured to reduce crystal cracking. In some embodiments, the cover plate 170 may be disposed above the upper insulation member 141. In some embodiments, the cover 170 may be a cylinder, a prismatic cone, or the like. In some embodiments, the material of the cover plate 170 may be the same as or different from the material of the insulation assembly 140.

In some embodiments, as shown in FIG. 1, penetrating holes are provided on the cavity cover 130, the upper insulation member 141, and the cover plate 170, allowing the connecting assembly 160 and the seed crystal holder 150 to pass through for rotation and/or up and down movement.

In some embodiments, the size of each of the hole on the cover plate 170 affects the amount of silicon volatilization. For example, the size of the hole on the cover plate 170 is too large, and heat is dissipated through the hole, increasing the amount of heat energy that needs to be provided by the heating assembly, which in turn increases the temperature of the melt and increases the amount of silicon volatilization. If the size of the hole on the cover 170 is too small, the connecting assembly 160 and the seed crystal holder 150 fail to pass through for rotation and/or up and down movement, which in turn the improper growth of crystal. Therefore, the diameter of the hole on the cover plate 170 needs to be within a predetermined range.

In some embodiments, the diameter of the hole on the cover plate 170 may be within a range of 20 mm-150 mm. In some embodiments, the diameter of each hole on the cover plate 170 may be within a range of 40 mm-120 mm. In some embodiments, the diameter of each hole on the cover plate 170 may be within a range of 50 mm to 100 mm. In some embodiments, the diameter of each hole on the cover plate 170 may be within a range of 70 mm-80 mm.

It should be noted that the foregoing description of the crystal preparation apparatus 100 is for the purpose of exemplification and illustration only, and does not limit the scope of application of the present disclosure. For a person skilled in the art, various modifications and changes can be made to the crystal preparation apparatus 100 under the guidance of the present disclosure. However, these modifications and changes remain within the scope of the present disclosure.

FIG. 2 is a schematic diagram illustrating through holes in an exemplary plate assembly according to some embodiments of the present disclosure. FIG. 3 is a schematic diagram illustrating through holes in an exemplary plate assembly according to some embodiments of the present disclosure.

In some embodiments, one or more through holes 1111 may be included in a plate assembly 111, as shown in FIG. 2 and FIG. 3. In some embodiments, the through holes 1111 may extend through the plate assembly 111. In some embodiments, the shape of the through holes 1111 may include circle, oval, polygonal, star, or other regular or irregular shapes. In some embodiments, the through holes 1111 on one of the plate assemblies 111 may have the same or different shapes. In some embodiments, the shape of the through holes 1111 on different plate assemblies 111 may be the same or different.

In some embodiments, through holes 1111 of adjacent plate assemblies 111 may be interleaved. For example, as shown in FIG. 2, through holes 1111 (shown in the solid portion of FIG. 2) on a plate assembly located above does not overlap with through holes 1111' (shown in dashed portion of FIG. 2) on a plate assembly located below. In some embodiments, through holes of adjacent plate assemblies being interleaved may indicate through holes of adjacent plate assemblies non-overlapping or partially overlapping with each other.

By interleaving the through holes 1111 on adjacent plate assemblies 111, the convection of the melt in the growth cavity 110 may be adjusted to reduce the rise rate of volatile components (e.g., silicon), reduce the amount of volatile components (e.g., silicon) on the surface of the melt, and reduce the amount of silicon carbide particles generated by the reaction of the volatile components (e.g., silicon vapors) and the graphite in the growth cavity 110, and further reduce the amount of volatile silicon or generated silicon carbide particles adhering to the upper insulation member and causing contamination or damage to the insulation assembly, thereby ensuring normal crystal growth.

A ratio of a sum of open areas of the one or more through holes 1111 on a plate assembly to an area of an upper surface of the plate assembly may affect the convection of the melt in the growth cavity 110, which may, in turn, affect the proper growth of the crystal. For example, if the ratio of the sum of the open areas of the one or more through holes 1111 on the plate assembly to the area of the upper surface of the plate assembly 111 is too large, the rise rate of the silicon cannot to be effectively improved, and accordingly, it is ineffective to reduce the volatilization of the silicon on the melt surface. As another example, if the ratio of the sum of the open areas of the one or more through holes 1111 to the area of the upper surface of one of the plate assemblies 111 on which the one or more through holes 1111 are located is too small, the resistance to the upward movement of the melt increases, and it is not possible to ensure that a sufficient amount of melt may be moved to a location near the seed crystal, which in turn affects the crystal growth rate. Therefore, in some embodiments, the ratio of the sum of the open areas of the one or more through holes 1111 to the area of the upper surface of one of the plate assemblies 111 on which the one or more through holes 1111 are located is required to satisfy a predetermined requirement.

In some embodiments, for at least one of the one or more plate assemblies 111, a ratio of a sum of open areas of one or more through holes 1111 on a plate assembly to an area of an upper surface of the plate assembly may be within a range of 30%-80%. In some embodiments, for at least one plate assembly 111 of the one or more plate assemblies 111, the ratio of the sum of the open areas of the one or more through holes 1111on the plate assembly to the area of the upper surface of the plate assembly 111 may be within a range of 35%-75%. In some embodiments, for at least one plate assembly 111 of the one or more plate assemblies, the ratio of the sum of the open areas of the one or more through holes 1111 on the plate assembly to the area of the upper surface of the plate assembly 111 may be within a range of 40%-70%. In some embodiments, for at least one plate assembly 111 of the one or more plate assemblies, the ratio of the sum of the open areas of the one or more through holes 1111 on the plate assembly to the area of the upper surface of the plate assembly 111 may be within a range of 45%-65%. In some embodiments, for at least one plate assembly 111 of the one or more plate assemblies 111, the ratio of the sum of the open areas of the one or more through holes 1111 on the plate assembly to the area of the upper surface of the plate assembly may be within a range of 50%-60%. In some embodiments, for at least one plate assembly 111 of the one or more plate assemblies 111, the ratio of the sum of the open areas of the one or more through holes 1111 on the plate assembly to the area of the upper surface of the plate assembly may be within a range of 52%-58%. In some embodiments, for at least one plate assembly 111 of the one or more plate assemblies 111, the ratio of the sum of the open areas of the one or more through holes 1111 on the plate assembly to the area of the upper surface of the plate assembly may be within a range of 54%-56%.

In some embodiments, for different plate assemblies 111, a ratio of a sum of open areas of one or more through holes 1111 on a plate assembly to an area of an upper surface of the plate assembly may be the same or different. In some embodiments, the ratio of the sum of the open areas of the one or more through holes 1111 on the plate assembly to the area of the upper surface of the plate assembly may gradually decrease or increase in a direction from the bottom portion to the top portion of the growth cavity 110. For example, as shown in FIG. 2, the ratio of the sum of the open areas of the through holes 1111 (shown in the solid portion of FIG. 2) on the plate assembly located above to the area of the upper surface of the plate assembly may be less than the ratio of the sum of the open areas of the through holes 1111' (shown in the dashed portion of FIG. 2) on the plate assembly located below to the area of the upper surface of the plate assembly.

In some embodiments, as shown in FIG. 3, the density of through holes 1111 (e.g., the number of through holes 1111 per unit area) on a plate assembly may be progressively reduced from the center to the edge of the plate assembly 111. In some embodiments, the density of through holes near the center of the plate assembly 111 may be higher than the density of through holes near the edge of the plate assembly 111. Correspondingly, it can be ensured that a sufficient amount of melt may move upwardly from the through holes 1111 located near the center of the plate assembly 111 to the seed crystals for crystallization and growth of crystals, which improves the convection of the melt and thus improves the over-consumption of silicon while ensuring crystal preparation efficiency.

It should be noted that in embodiments of the present disclosure, "near" refers to within a predetermined distance. In some embodiments, the predetermined distance may include 10 cm, 8 cm, 6 cm, 4 cm, 2 cm, 1 cm, or the like. In some embodiments, a region "near the center" of the plate assembly 111 refers to a region of the plate assembly centered on the center of the plate assembly 111 with a radius of the predetermined distance. In some embodiments, a region "near the edge" of the plate assembly 111 refers to a region of the plate assembly within a predetermined distance from the edge of the plate assembly 111.

A too small ratio of a density of the through holes near the center of the plate assembly 111 to the density of the through holes near the edge of the plate assembly 111 may lead to natural nucleation or a larger rate of natural nucleation of silicon carbide on the inner wall of the growth cavity 110, and the too large ratio of the density of the through holes near the center of the plate assembly 111 to the density of the through holes near the edge of the plate assembly 111 may result in the crystal center growing too fast and being prone to forming packages and cracking. Thus, in some embodiments, the ratio of the density of the through holes near the center of the plate assembly 111 to the density of the through holes near the edge of the plate assembly 111 needs to be within a predetermined range.

In some embodiments, the ratio of the density of the through holes near the center of the plate assembly 111 to the density of the through holes near the edge of the plate assembly 111 may be within a range of 1: 1-20: 1. In some embodiments, the ratio of the density of the through holes near the center of the plate assembly 111 to the density of the through holes near the edge of the plate assembly 111 may be within a range of 1:1-18:1. In some embodiments, the ratio of the density of the through holes near the center of the plate assembly 111 to the density of the through holes near the edge of the plate assembly 111 may be within a range of 1:1-16:1. In some embodiments, the ratio of the density of the through holes near the center of the plate assembly 111 to the density of the through holes near the edge of the plate assembly 111 may be within a range of 1:1-14:1. In some embodiments, the ratio of the density of the through holes near the center of the plate assembly 111 to the density of the through holes near the edge of the plate assembly 111 may be within a range of 1:1-12:1. In some embodiments, the ratio of the density of the through holes near the center of the plate assembly 111 to the density of the through holes near the edge of the plate assembly 111 may be within a range of 1:1-10:1. In some embodiments, the ratio of the density of the through holes near the center of the plate assembly 111 to the density of the through holes near the edge of the plate assembly 111 may be within a range of 1:1-8:1. In some embodiments, the ratio of the density of the through holes near the center of the plate assembly 111 to the density of the through holes near the edge of the plate assembly 111 may be within a range of 1:1-6:1. In some embodiments, the ratio of the density of the through holes near the center of the plate assembly 111 to the density of the through holes near the edge of the plate assembly 111 may be within a range of 1:1-5:1. In some embodiments, the ratio of the density of the through holes near the center of the plate assembly 111 to the density of the through holes near the edge of the plate assembly 111 may be within a range of 1.5:1 -4.5:1. In some embodiments, the ratio of the density of the through holes near the center of the plate assembly 111 to the density of the through holes near the edge of the plate assembly 111 may be within a range of 2:1-4:1. In some embodiments, the ratio of the density of the through holes near the center of the plate assembly 111 to the density of the through holes near the edge of the plate assembly 111 may be within a range of 2.5:1-3.5:1. In some embodiments, the ratio of the density of the through holes near the center of the plate assembly 111 to the density of the through holes near the edge of the plate assembly 111 may be within a range of 2.8:1-3.2:1.

The diameters of the through holes 1111 affects the convection of the melt within the growth cavity 110, which in turn affects the proper growth of the crystal. For example, the too large diameters of the through holes 1111 cannot effectively improve the rise rate of silicon, and accordingly, cannot effectively reduce the volatilization of silicon from the melt surface. As another example, if the diameter of the through holes 1111 is too small, the resistance to upward movement of the melt increases, and it is not possible to ensure that a sufficient amount of the melt may be moved to of the location near the seed crystal, thereby affecting the crystal growth rate. Therefore, in some embodiments, the diameter of the through holes 1111 needs to meet a predetermined requirement.

In some embodiments, the diameters of the through holes 1111 may be within a range of 0.1mm-10mm. In some embodiments, the diameters of the through holes 1111 may be within a range of 0.1mm-9mm. In some embodiments, the diameters of the through holes 1111 may be within a range of 0.1mm-8mm. In some embodiments, the diameters of the through holes 1111 may be within a range of 0.1mm-7mm. In some embodiments, the diameters of the through holes 1111 may be within a range of 0.1mm-6mm. In some embodiments, the diameters of the through holes 1111 may be within a range of 0.1mm-5mm. In some embodiments, the diameters of the through holes 1111 may be within a range of 0.1mm-5mm. In some embodiments, the diameters of the through holes 1111 may be within a range of 0.5mm-4.5mm. In some embodiments, the diameters of the through holes 1111 may be within a range of 1mm-4mm. In some embodiments, the diameters of the through holes 1111 may be within a range of 1.5mm-3.5mm. In some embodiments, the diameters of the through holes 1111 may be within a range of 2mm-3mm. In some embodiments, the diameters of the through holes 1111 may be within a range of 2.4mm-2.6mm.

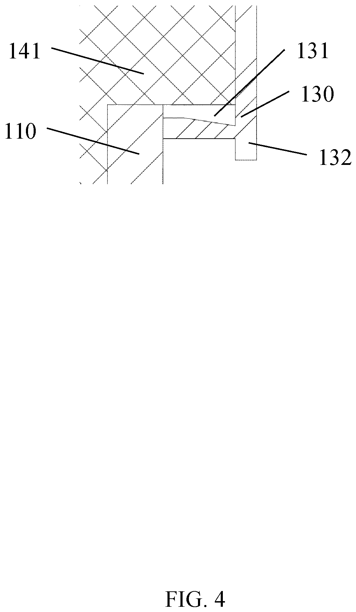

FIG. 4 is a schematic diagram illustrating a localized structure of an exemplary cavity cover with an upper insulation member according to some embodiments of the present disclosure.

As previously described, during the crystal preparation process, silicon may move upwardly from the bottom portion of the growth cavity 110 or even evaporate to a gaseous state and continue to overflow upwardly as silicon vapors. Silicon vapors may spill out of the cavity cover 130 and then condense upon cooling, adhering to the surface of the upper insulation member 141, affecting its insulation properties. Accordingly, in some embodiments, as shown in FIG. 4, a gap 131 may exist between the cavity cover 130 and the upper insulation member 141, and the gap 131 may be filled with carbon powder to allow the volatile silicon vapor to react with the carbon powder, so that the silicon vapor may be avoided from overflowing and condensing upon cooling and adhering to the surface of the upper insulation member 141, or the silicon carbide particles generated by the reaction of the silicon vapor with the growth cavity 110 may be avoided from adhering to the insulation assembly to affect the insulation performance.

In some embodiments, as shown in FIG. 4, the cavity cover 130 may further include a raised structure 132. Due to the lower temperature (lower than the melt temperature) near the raised structure 132, some of the silicon vapors may condense at the raised structure 132 to slow down or reduce the spillover of silicon vapor and reduce the contamination degree of the upper insulation member 141. After the crystal growth is finished, the raised structure 132 may be cleaned and processed to facilitate subsequent usage.

FIG. 5 is a schematic diagram illustrating an exemplary growth cavity according to some embodiments of the present disclosure.

In conjunction with the foregoing, in the crystal preparation process, the raw material needs to be melted into a melt (liquid state) and the crystal is grown based on the melt, and the growth cavity 110 needs to be provided with a carbon source for the crystal growth. As a result, the bottom portion (or a lower middle portion) of the growth cavity 110 is warmer and more rapidly depleted.

Accordingly, in some embodiments, the thickness of the sidewall of the growth cavity 110 gradually increases along the direction from the top portion to the bottom portion of the growth cavity 110 (in the direction indicated by the arrows in FIG. 5), which accordingly prevents the bottom portion from being thinned by excessive consumption, and further allows for an increase in the number of times the growth cavity 110 may be used.

FIG. 6 is a schematic diagram illustrating an exemplary seed crystal holder and a seed crystal according to some embodiments of the present disclosure.

In the crystal preparation process, if the seed crystal is too thin, a burn-through phenomenon is likely to occur, which affects the effect of the crystal preparation. In addition, because the seed crystal is too thin, the seed crystal holder may unavoidably come into contact with the melt, generating crystals having different crystal types and/or crystallographic orientations from that of the seed crystal, thus generating crystal defects. However, if a seed crystal with a large thickness is used directly, the cost of the seed crystal preparation will be greatly increased.

Accordingly, in some embodiments, the one or more seed crystal may be arranged in at least two layers. A seed crystal used for crystal growth (i.e., the lowermost layer of seed crystals in direct contact with the melt) is of a higher quality, and the other layers of seed crystals may be of a relatively lower quality, which accordingly allows for a reduction in cost while increasing the overall thickness of the seed crystal.

In some embodiments, the at least two layers of seed crystals may include a first seed crystal 181 and a second seed crystal 182, as illustrated in FIG. 6. The mass of the first seed crystal 181 may be lower than the mass of the second seed crystal 182.

In some embodiments, if the second seed crystal 182 meets the needs of the crystal growth, the thickness of the first seed crystal 181 may be greater than the thickness of the second seed crystal 182 to further reduce the cost of the seed crystal 180.

In some embodiments, the bonding between the seed crystal holder 150 and the first seed crystal 181, and the bonding between the first seed crystal 181 and the second seed crystal 182 may include, but is not limited to, adhesive bonding, photopolymerization, or the like.

The unavoidable presence of a certain gap in the seed crystal holder 150 may lead to the escape of gas-phase material accumulated in the gap or porous regions of the backside of the seed crystal (e.g., the bonding surface of the first seed crystal 181 to the seed crystal holder 150), which may lead to defects (e.g., planar hexagonal hollow defects) in the final prepared crystal.

Thus, in some embodiments, as shown in FIG. 6, a graphite paper 190 may be filled between the seed crystal holder 150 and the seed crystal 180 (the first seed crystal 181). The graphite paper 190 is softer and flatter, which reduces the porosity of the bonding surface, prevents uneven heating of the backside of the seed crystals, reduces subsequent defects, and improves the strength of the bond between the seed crystal holder 150 and the seed crystal 180 (e.g., the first seed crystal 181).

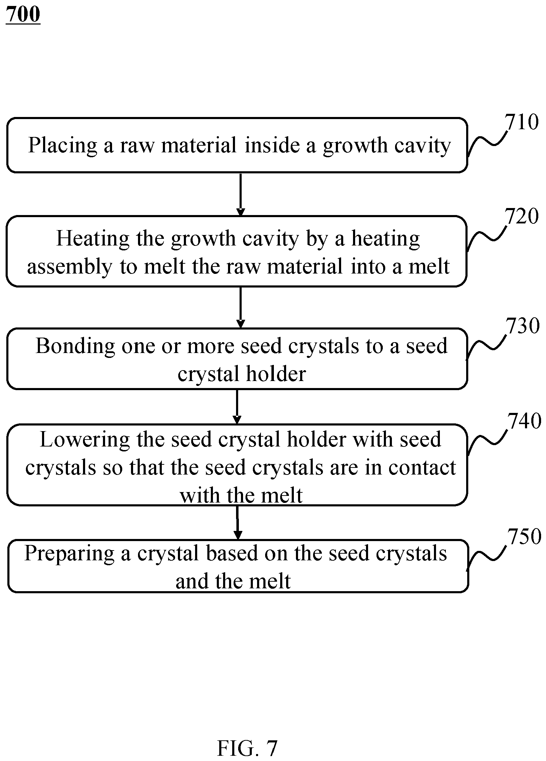

FIG. 7 is a flowchart illustrating an exemplary crystal preparation process according to some embodiments of the present disclosure. In some embodiments, process 700 may be performed by one or more components of a crystal preparation apparatus (e.g., the crystal preparation apparatus 100). In some embodiments, the process 700 may be automatically executed by a control system. For example, the process 700 may be realized by control instructions, and the control system, based on the control instructions, controls various components to perform various operations of the process 700. In some embodiments, the process 700 may be executed semi-automatically. For example, one or more operations of the process 700 may be manually performed by an operator. In some embodiments, when completing the process 700, one or more additional operations not described may be added, and/or one or more operations discussed herein may be deleted. Additionally, the order of the operations shown in FIG. 7 is not limiting. As shown in FIG. 7, the process 700 includes the following operations.

In 710, a raw material is placed inside a growth cavity.

In some embodiments, the raw material refers to a raw material needed to grow crystals. For example, when growing silicon carbide crystal, the raw material may include silicon (e.g., silicon powder, silicon wafer, silicon block). As another example, when growing silicon carbide crystal, the raw material may include silicon and carbon (e.g., carbon powder, carbon block, carbon particle). In some embodiments, the raw material includes carbon powder, carbon block, or carbon particle, which may increase the number of times the growth cavity is used. In some embodiments, the raw material may also include a flux to increase the solubility of carbon in silicon. In some embodiments, the flux may include, but is not limited to, aluminum, silicon-chromium alloys, Li-Si alloys, Ti-Si alloys, Fe-Si alloys, Sc-Si alloys, Co-Si alloys.

In some embodiments, each of one or more plate assemblies may be arranged in a layer within the growth cavity. Related descriptions of the growth cavity (e.g., the growth cavity 110) and the at least one layer of plate assemblies (e.g., the plate assemblies 111) may be found elsewhere in the present disclosure (e.g., FIGs. 1-FIG. 5 and their depictions) and will not be repeated herein.

In 720, the growth cavity is heated by a heating assembly to melt the raw material into a melt.

For example, when growing silicon carbide crystal, the raw material is melted to form a solution of carbon in silicon, which serves as a liquid raw material for crystal growth.

Related descriptions of the heating assembly (e.g., the heating assembly 120) may be found elsewhere in the present disclosure (e.g., FIG. 1 and its description) and will not be repeated here.

In some embodiments, a ratio of the height of the melt to the height of the growth cavity needs to be within a predetermined range in order to improve the utilization of the raw material. In some embodiments, the ratio of the height of the melt to the height of the growth cavity may be within a range of 1:1-1:5. In some embodiments, the ratio of the height of the melt to the height of the growth cavity may be within a range of 1:1.5-1:4.5. In some embodiments, the ratio of the height of the melt to the height of the growth cavity may be within a range of 1 :2-1:4. In some embodiments, the ratio of the height of the melt to the height of the growth cavity may be within a range of 1 :2.5-1 :3.5. In some embodiments, the ratio of the height of the melt to the height of the growth cavity may be within a range of 1:2.8-1:3.

In some embodiments, the melt level may be located near the midpoint of the height of the heating assembly (e.g., an induction coil) to improve the stability of the crystal growth. In some embodiments, "near" refers to within a predetermined distance. In some embodiments, the predetermined distance may include ±50 cm, ±40 cm, ±30 cm, ±20 cm, ±10 cm, ±8 cm, ±6 cm, ±4 cm, ±2 cm, ±1 cm etc. For example, after the raw material is melted into the melt, the melt level may be located within ±30 cm of 1/2 the height of the heating assembly (e.g., an induction coil).

In 730, one or more seed crystals are bonded to a seed crystal holder.

In some embodiments, the seed crystals may be arranged in at least two layers. In some embodiments, the at least two layers of seed crystals may include a first seed crystal and a second seed crystal. The first seed crystal may be bonded to the seed crystal holder, and the second seed crystal may be bonded to the first seed crystal. In some embodiments, the mass of the first seed crystal may be lower than the mass of the second seed crystal.

In some embodiments, before bonding the seed crystals to the seed crystal holder, a graphite paper may be bonded to the seed crystal holder such that the graphite paper is disposed between the seed crystal holder and a seed crystal. In some embodiments, the seed crystals and/or the graphite paper may be concentric with the seed crystal holder.

In some embodiments, the thickness of the graphite paper may be within a range of 0.5 mm-1 mm. In some embodiments, the thickness of the graphite paper may be within a range of 0.6 mm-0.9 mm. In some embodiments, the thickness of the graphite paper may be within a range of 0.5 mm-1 mm. In some embodiments, the thickness of the graphite paper may be within a range of 0.7 mm-0.8 mm.

In some embodiments, to ensure bond strength between the graphite paper, the first seed crystal, and the second seed crystal, and to ensure crystal quality, the flatness of the surface of the first seed crystal is required to satisfy a predetermined condition. In some embodiments, the flatness of the surface of the first seed crystal adhered to the graphite paper may be less than 0.01 mm. In some embodiments, the flatness of the surface of the first seed crystal adhered to the second seed crystal may be within a range of 0.005 mm-0.008 mm. In some embodiments, the flatness of the surface of the first seed crystal affixed to the second seed crystal may be within a range of 0.006 mm-0.007 mm.

Related descriptions of the seed crystals (e.g., the seed crystal 180) and seed crystal holder (e.g., the seed crystal holder 150) may be found elsewhere in the present disclosure (e.g., FIG. 6 and its description) and will not be repeated here.

In 740, the seed crystal holder with the seed crystals is lowered so that the seed crystals are in contact with the melt.

In some embodiments, the connecting assembly may be driven down by the power assembly to drive the seed crystal holder down to bring the seed crystals into contact with the melt.

In 750, a crystal is prepared based on the seed crystals and the melt.

In some embodiments, the connecting assembly may be driven by the power assembly to rotate and/or move up and down to drive the seed crystal holder to rotate and/or move up and down, and the melt may be condensed and crystallized at the seed crystals to grow the crystal.

During the crystal growth process, convection occurs in the melt inside the growth cavity, and the silicon in the lower portion moves upwardly. Part of the silicon may be blocked by the plate assemblies disposed inside the growth cavity, and part of the silicon may continue to move upwardly through the through holes on the plate assemblies. Some of the silicon that continues to move upward may be blocked by the plate assemblies above it due to the through holes on adjacent plate assemblies being interlaced. By repeating this process, the amount of silicon flowing from the melt to the surface of the melt may be significantly reduced. Accordingly, the volatilization of the silicon on the upper surface of the melt may be reduced, which further may reduce the contamination degree of the insulation member, maintain the insulation performance of the insulation member, and further ensure the normal growth of the crystal.

It should be noted that the foregoing description of the process 700 is intended to be exemplary and illustrative only and does not limit the scope of application of the present disclosure. For a person skilled in the art, various corrections and changes may be made to the process 700 under the guidance of this application. However, these corrections and changes remain within the scope of the present disclosure.

The embodiments of the present disclosure include but are not limited to the following beneficial effects. First, one or more plate assemblies each of which is arranged in a layer are provided inside the growth cavity, and the material of the plate assemblies includes graphite, which may be used as a carbon source to provide the raw material required for the preparation of the silicon carbide crystals. Second, the plate assemblies include through holes, and the through holes on the adjacent plate assemblies are staggered, which may regulate the convection of the melt inside the growth cavity, reduce the volatile components (e.g., silicon), reduce the volatility of volatile components (e.g., silicon) on the surface of the melt, reduce the excessive consumption of volatile components, and reduce the silicon carbide particles generated by the reaction of volatile components (e.g., silicon vapor) with the growth cavity, which further reduces the contamination degree of the insulation member, ensures the insulation performance of the insulation member, and further ensures the normal growth of the crystal. Third, the upper portion with the predetermined range of the sidewall of the growth cavity is coated with a coating or provided with a shielding ring, which avoids the reaction between the silicon on the surface of the melt and the carbon on the sidewall of the growth cavity, thereby avoiding spontaneous nucleation of crystalline growth. Fourth, there is a gap between the cavity cover and the upper insulation member, which is filled with carbon powder. The carbon powder may react with the volatile silicon vapor to prevent silicon vapor from overflowing to the insulation member, or to prevent the silicon carbide particles generated by the reaction between the silicon vapor and the growth cavity from attaching to the insulation member and affecting its insulation performance. Fifth, the cavity cover includes a raised structure, which allows part of the silicon vapor to condense at the raised structure to slow down or reduce the overflow of silicon vapor and reduce the contamination degree of the insulation member. Sixth, the seed crystals include one or more seed crystals arrange in at least two layers, which may increase the thickness of the seed crystals, reduce the risk of the seed crystals being burned through, and further ensure the quality of the produced crystals. Seventh, the mass of the first seed crystal bonded to the seed crystal holder may be lower than the mass of the second seed crystal bonded to the first seed crystal, which reduces the cost of the seed crystals and further reduce the cost of the crystal preparation. It should be noted that the beneficial effects that may be produced by different embodiments are different, and the beneficial effects that may be produced in different embodiments may be any one or a combination of any one or a combination of any of the foregoing, or any other beneficial effect that may be obtained.

Having thus described the basic concepts, it may be rather apparent to those skilled in the art after reading this detailed disclosure that the foregoing detailed disclosure is intended to be presented by way of example only and is not limiting. Although not explicitly stated here, those skilled in the art may make various modifications, improvements, and amendments to the present disclosure. These alterations, improvements, and amendments are intended to be suggested by this disclosure and are within the spirit and scope of the exemplary embodiments of the present disclosure.

Moreover, certain terminology has been used to describe embodiments of the present disclosure. For example, the terms "one embodiment," "an embodiment, " and/or "some embodiments" mean that a particular feature, structure, or feature described in connection with the embodiment is included in at least one embodiment of the present disclosure. Therefore, it is emphasized and should be appreciated that two or more references to "an embodiment", "one embodiment", or "an alternative embodiment" in various portions of the present disclosure are not necessarily all referring to the same embodiment. In addition, some features, structures, or characteristics of one or more embodiments in the present disclosure may be properly combined.

Similarly, it should be appreciated that in the foregoing description of embodiments of the present disclosure, various features are sometimes grouped together in a single embodiment, figure, or description thereof for the purpose of streamlining the disclosure aiding in the understanding of one or more of the various embodiments. However, this disclosure does not mean that object of the present disclosure requires more features than the features mentioned in the claims. Rather, claimed subject matter may lie in less than all features of a single foregoing disclosed embodiment.

In some embodiments, the numbers expressing quantities or properties used to describe and claim certain embodiments of the present disclosure are to be understood as being modified in some instances by the term "about", "approximate", or "substantially". For example, "about", "approximate", or "substantially" may indicate ±20% variation of the value it describes, unless otherwise stated. Accordingly, in some embodiments, the numerical parameters set forth in the written description and attached claims are approximations that may vary depending upon the desired properties sought to be obtained by a particular embodiment. In some embodiments, the numerical parameters should be construed in light of the number of reported significant digits and by applying ordinary rounding techniques. Notwithstanding that the numerical ranges and parameters setting forth the broad scope of some embodiments of the present disclosure are approximations, the numerical values set forth in the specific examples are reported as precisely as practicable.

Each of the patents, patent applications, publications of patent applications, and other material, such as articles, books, specifications, publications, documents, things, and/or the like, referenced herein is hereby incorporated herein by this reference in its entirety for all purposes. History application documents that are inconsistent or conflictive with the contents of the present disclosure are excluded, as well as documents (currently or subsequently appended to the present specification) limiting the broadest scope of the claims of the present disclosure. By way of example, should there be any inconsistency or conflict between the description, definition, and/or the use of a term associated with any of the incorporated material and that associated with the present document, the description, definition, and/or the use of the term in the present document shall prevail.

In closing, it is to be understood that the embodiments of the present disclosure disclosed herein are illustrative of the principles of the embodiments of the present disclosure. Other modifications that may be employed may be within the scope of the present disclosure. Thus, by way of example, but not of limitation, alternative configurations of the embodiments of the present disclosure may be utilized in accordance with the teachings herein. Accordingly, embodiments of the present disclosure are not limited to that precisely as shown and described.

## Claims

1. A crystal preparation apparatus, comprising:
a growth cavity provided with one or more plate assemblies, each of the one or more plate assemblies being arranged as a layer; and
a heating assembly configured to heat the growth cavity.

2. The crystal preparation apparatus of claim 1, wherein one of the one or more plate assemblies includes one or more through holes.

3. The crystal preparation apparatus of claim 2, wherein through holes of adjacent plate assemblies are interleaved.

4. The crystal preparation apparatus of claim 2, wherein, for a plate assembly of the one or more plate assemblies, a ratio of a sum of open areas of the one or more through holes to an area of an upper surface of the plate assembly is within a range of 30%-80%.

5. The crystal preparation apparatus of claim 2, wherein a density of the one or more through holes decreases progressively from a center to an edge of a plate assembly among the one or more plate assemblies.

6. The crystal preparation apparatus of claim 2, wherein a ratio of a density of through holes near a center of a plate assembly among the one or more plate assemblies to a density of through holes near an edge of the plate assembly is within a range of 1: 1-20: 1.

7. The crystal preparation apparatus of claim 2, wherein a diameter of each of the one or more through holes is within a range of 0.1 mm-10 mm.

8. The crystal preparation apparatus of claim 1, wherein the one or more plate assemblies are disposed within a melt within the growth cavity and is disposed at a predetermined distance below a liquid level of the melt.

9. The crystal preparation apparatus of claim 1, wherein a distance between adjacent plate assemblies is within a range of 10 mm-60 mm.

10. The crystal preparation apparatus of claim 1, wherein an upper portion with a predetermined range of a sidewall of the growth cavity is coated with a coating or provided with a shielding ring.

11. The crystal preparation apparatus of claim 10, wherein the predetermined range is within a range of 0-2/3 along a height direction of the growth cavity.

12. The crystal preparation apparatus of claim 1, further comprising a cavity cover and an upper insulation member, wherein a gap between the cavity cover and the upper insulation member is filled with toner.

13. The crystal preparation apparatus of claim 12, wherein the cavity cover includes a raised structure.

14. The crystal preparation apparatus of claim 1, wherein a thickness of a sidewall of the growth cavity is progressively increased in a direction from a top portion to a bottom portion of the growth cavity.

15. The crystal preparation apparatus of claim 1, further comprising a seed crystal holder configured to bond one or more seed crystals, wherein the one or more seed crystals are arranged in at least two layers.

16. The crystal preparation apparatus of claim 1, wherein the heating assembly includes an induction coil, the induction coil is disposed around an outer periphery of the growth cavity, a ratio of a height of the growth cavity to a height of the induction coil is within a range of 1:1-1:5.

17. A crystal preparation method, comprising:
placing a raw material within a growth cavity, wherein the growth cavity is provided with one or more plate assemblies, each of the one or more plate assemblies is arranged as a layer;
heating the growth cavity by a heating assembly to melt the raw material into a melt;
bonding one or more seed crystals to a seed crystal holder;
lowering the seed crystal holder with the one or more seed crystals so that the one or more seed crystals are in contact with the melt; and
preparing a crystal based on the one or more seed crystals and the melt.

18. The crystal preparation method of claim 17, wherein the one or more seed crystals are arranged in at least two layers, the one or more seed crystals include a first seed crystal and a second seed crystal, the first seed crystal is bonded to the seed crystal holder, the second seed crystal is bonded to the first seed crystal, and a mass of the first seed crystal is lower than a mass of the second seed crystal.

19. The crystal preparation method of claim 17, wherein a graphite paper is filled between the seed crystal holder and the one or more seed crystals.

20. The crystal preparation method of claim 17, wherein a ratio of a height of the melt to a height of the growth cavity is within a range of 1:1-1:5.
